# EUROPÄISCHE PATENTSCHRIFT

(11) **EP 1 425 846 B1**
(45) Veröffentlichungstag und Bekanntmachung des Hinweises auf die Patenterteilung: **15.11.2006**
(21) Anmeldenummer: 02774345.9
(22) Anmeldetag: 12.09.2002
(51) Int. Cl.: H03D 1/00

(54) **SENDEANORDNUNG, INSBESONDERE FÜR DEN MOBILFUNK**
TRANSMITTER ARRANGEMENT ESPECIALLY FOR MOBILE RADIO
DISPOSITIF D'EMISSION DESTINE NOTAMMENT A LA TELEPHONIE MOBILE

(30) Priorität: 12.09.2001 DE 10144907
(43) Veröffentlichungstag der Anmeldung: 09.06.2004
(73) Patentinhaber: Infineon Technologies AG, 81669 München (DE)
(72) Erfinder: SIMON, Martin, 83624 Otterfing (DE)
(74) Vertreter: Epping - Hermann - Fischer
(86) Internationale Anmeldenummer: PCT/DE2002/003399
(87) Internationale Veröffentlichungsnummer: WO 2003/023948

(56) Entgegenhaltungen:
- EP-A- 0 588 444
- EP-A- 1 039 628
- WO-A-00/31941
- WO-A-00/57545
- US-A- 4 816 783
- US-A- 5 559 468
- US-A- 5 847 623
- US-A- 6 016 422

## Beschreibung

Die vorliegende Erfindung betrifft eine Sendeanordnung, insbesondere für den Mobilfunk.

Moderne, breitbandige Mobilfunksysteme setzen zum Erzielen einer höheren Bandbreite neben einer Phasenmodulation zusätzlich eine Amplitudenkomponente bei der Modulation ein, um den höheren Anforderungen an die Daten-Übertragungsraten gerecht werden zu können.

Derartige, lineare Modulationsverfahren, wie beispielsweise im Standard GSM EDGE, Global System for Mobile Communication, vorgesehen, stellen jedoch höhere Anforderungen an die Linearitätseigenschaften von Sende- und Empfangsanordnungen im Mobilfunk sowie an die Träger- und Seitenbandunterdrückung am Ausgang einer Sendeanordnung. Diese wiederum sind ahhängig von Fertigungstoleranzen, insbesondere Paarungstoleranzen der verwendeten Bauteile in einer Sendeanordnung.

Quadraturmodulatoren in Sendeanordnungen für den Mobilfunk, denen beispielsweise ein komplexes Basisbandsignal zuführbar ist, welches auf eine Trägerfrequenz aufmoduliert wird, erfordern ein Lokaloszillatorsignal, welches ebenfalls aus zwei um 90° zueinander verschobenen Komponenten besteht. Abweichungen von der Signalorthogonalität, das heißt von der Phasenverschiebung von 90° des Trägersignals, führen, beispielsweise aufgrund von zu großen Paarungstoleranzen der Bauteile in einem vorgeschalteten Frequenzteiler, zu einer zu geringen Seitenbandunterdrückung im Frequenzmischer beziehungsweise im IQ-Modulator.

Weiterhin verursachen Offsetspannungen im Basisbandsignal, die beispielsweise aufgrund von Fehlanpassungen der verwendeten Bauelemente enstehen können, eine zu geringe Trägerunterdrückung im Mobilfunksender. Die Trägerünterdrückung kann aufgrund unzureichender Isolation zwischen LokaloszillatorSignaleingang und Signalausgang des Modulators, welche ein Übersprechen des Trägersignals auf den Modulatorausgang bedingt, zusätzlich verschlechtert sein. Zu geringe Träger- und Seitenbandunterdrückungen jedoch erzeugen einen Phasenfehler im digital modulierten Ausgangssignal der Sendeanordnung.

In dem Dokument M. Faulkner, T. Mattsson, W. Yates "Automatic Adjustment of Quadrature Modulators", Electronics Letters, 31st January 1991, Vol. 27 No. 3, pp. 214 - 216, ist ein Quadraturmodulator mit einem Rückkopplungspfad angegeben, welcher derart auf ein Korrekturnetzwerk am Eingang des Modulators einwirkt, daß Phasenfehler sowie Offsetfehler der Sendeanordnung durch entsprechende Vorverzerrung des Basisbandsignals kompensiert werden. Im Rückkopplungspfad, der an den Ausgang des Modulators angeschlossen ist, ist dabei jedoch ein Richtkoppler zum Auskoppeln des Hochfrequenz-Sendesignals, ein zusätzlicher Verstärker sowie ein nachgeschalteter Leistungsdetektor erforderlich, welche einen verhältnismäßig großen Chipflächenbedarf, eine zusätzliche, unerwünschte Stromaufnahme sowie höhere Kosten bei der Herstellung verursachen.

Das Dokument EP 1039628 A1 zeigt einen integrierbaren Hochfrequenz-Sender. Ein Inphase- und ein Quadratursignal werden auf eine Zwischen- und anschließend nach Digitalisierung auf eine Hochfrequenzebene konvertiert. In einer Rückführung ist eine Konversion auf eine Zwischenfrequenzebene mit nachfolgender Digitalisierung zur Kompensation in Verstärkung und Phase vorgesehen.

Aufgabe der vorliegenden Erfindung ist es, eine Sendeanordnung, insbesondere für den Mobilfunk anzugeben, welche unter Beibehaltung einer für lineare Modulationsverfahren erforderlichen Träger- und Seitenbandunterdrückung mit geringem Aufwand realisierbar und für die Massenherstellung geeignet ist.

Erfindungsgemäß wird die Aufgabe gelöst durch eine Sendeanordnung, insbesondere für den Mobilfunk, aufweisend die Merkmale des Patentanspruchs 1.

In der vorgeschlagenen, erfindungsgemäßen Sendeanordnung ist ein Rückkopplungspfad zwischen Ausgang des Quadraturmodulators und einer digitalen Signalverarbeitungseinheit vorgesehen, welche mit dem Eingang des Quadraturmodulators, beispielsweise über DA(Digital/Analog)-Wandler, gekoppelt ist. Im Rückkopplungspfad ist zur Gewinnung der Einhüllenden, der sogenannten Envelope, des modulierten Sendesignals ein Analog/Digital-Wandler vorgesehen. In der digitalen Signalverarbeitungseinheit ist gemäß dem vorgeschlagenen Prinzip ein Vorverzerrungsnetzwerk vorgesehen, welches die Phasenlage von Inphase- und Quadraturkomponente des komplexwertigen Nutzsignals zueinander und/oder die Amplitude von Inphase- oder Quadraturkomponente beispielsweise durch Addition eines digitalen Offsets zu einer der beiden Signalkomponenten, bewirkt. Während erstere eine Seitenbandunterdrückung gewährleistet, bewirkt letztere eine Trägerunterdrückung, jeweils auch bei Fehlanpassungen (englisch: Mismatch) der Bauteile im Sender.

Die vorgeschlagene Sendeanordnung ermöglicht bei besonders einfachem Aufbau ohne zusätzlichen Aufwand, denn ein Analog/Digital-Wandler ist im Rückkopplungspfad ohnehin vorzusehen, eine gute Träger- und Seitenbandunterdrückung und damit den Betrieb der Anordnung mit linearen Modulationsverfahren wie GSM EDGE.

Der AD-Wandler im Rückkopplungspfad ist für eine Unterabtastung des modulierten Sendesignals bezogen auf die Trägerfrequenz des modulierten Sendesignals am Eingang des AD-Wandlers ausgelegt. Unterabtastung bedeutet dabei, daß die Abtastfrequenz des AD-Wandlers geringer ist als die Trägerfrequenz des modulierten, hochfrequenten Sendesignals, jedoch gemäß dem Abtasttheorem groß genug ist, um die Einhüllende des modulierten Sendesignals, demnach das Modulationssignal selbst oder ein hiervon abgeleitetes Signal, rückgewinnen zu können.

Gemäß einer alternativen, erfindungsgemäßen Sendeanordnung ist im Rückkopplungspfad ein Abwärts-Frequenzumsetzer vorgesehen, der den Modulatorausgang mit der digitalen Signalverarbeitungseinheit koppelt.

Der Abwärtsmischer konvertiert das Modulator-Ausgangssignal von der hochfrequenten Lage in eine niederfrequente Lage.

Ein derart heruntergemischtes, vom modulierten Sendesignal abgeleitetes Signal kann beispielsweise über einen. Tiefpaßfilter und einen AD-Wandler zur Vorverzerrung der Inphase- und Quadraturkomponenten des Nutzsignals der digitalen Signalverarbeitungseinheit zugeführt werden.

Der Abwärtsmischer ersetzt einen Richtkoppler mit nachgeschaltetem Leistungsdetektor und ermöglicht eine Sendeanordnung mit besonders einfachem Aufbau, welche für die Massenherstellung geeignet ist.

Den beiden vorgestellten, alternativen Lösungen gemäß der vorliegenden Erfindung ist gemeinsam, daß mit dem beschriebenen Abgleich durch Vorverzerrung sowohl fertigungsbedingte Fehlanpassungen und Bauteiltoleranzen kompensiert werden können, als auch Temperaturdrifts sowie Alterungserscheinungen der Bauteile kompensiert werden können. Bezüglich der Ausführung des Rückkopplungspfades mit Richtkoppler, Verstärker und Leistungsdetektor bieten die vorliegenden Ausführungsformen neben dem geringeren Aufwands zusätzlich einen höheren Dynamikbereich.

In einer weiteren, bevorzugten Ausführungsform der vorliegenden Erfindung umfaßt der Quadratur-Modulator zwei Gilbert-Multiplizierer, die ausgangsseitig über ein Summierglied miteinander verkoppelt sind.

Normalerweise erfordert ein Quadraturmodulator, der mit zwei Gilbert-Multiplizierern aufgebaut ist, eine enge Paarungstoleranz der verwendeten Mischerzellen. Aufgrund der mit der vorliegenden Anordnung ermöglichten Vorverzerrungs- beziehungsweise Abgleicheinrichtung können bei vorliegender Anordnung jedoch Fehlanpassungen in einfacher Weise vorkompensiert werden, so daß bei kostengünstiger Massenherstellung dennoch eine gute Träger- und Seitenbandunterdrückung gewährleistet ist.

In einer weiteren, bevorzugten Ausführungsform der vorliegenden Erfindung ist zwischen Rückkopplungspfad und Ausgang des Quadraturmodulators.ein Bandpaßfilter angeschlossen.

rn einer Sendeanordnung, insbesondere für den Mobilfunk, ist am Ausgang eines Modulators zur Kopplung an eine Sendeantenne üblicherweise ein Leistungsverstärker vorgesehen, dem ein Bandpaßfilter zur Bandbegrenzung des Sendesignals vorgeschaltet ist. Der Abgriff für den Rückkopplungspfad kann bevorzugt zwischen Bandpaßfilterausgang und Leistungsvertärkereingang angeschlossen sein.

In einer weiteren, bevorzugten Ausführungsform der vorliegenden Erfindung ist im Rückkopplungspfad ein Tiefpaßfilter vorgesehen, das dem Analog/Digital-Wandler vorgeschaltet ist.

In einer weiteren, bevorzugten Ausführungsform der vorliegenden Erfindung ist zur Kopplung von digitaler Signalverarbeitungseinheit und Quadraturmodulator sowohl in einem Inphasezweig, als auch in einem Quadraturzweig zum Führen des komplexwertigen Nutzsignals jeweils ein Digital/Analog-Wandler mit nachgeschaltetem Tiefpaß-Filter vorgesehen.

In einer weiteren, bevorzugten Ausführungsform der vorliegenden Erfindung umfaßt die digitale Signalverarbeitungseinheiteinen Speicher zum Ablegen von Vorverzerrungsinformationen, die in einem Einstellbetrieb in Abhängigkeit von der Einhüllenden ermittelt werden.

Der Einstellbetrieb kann beispielsweise gekennzeichnet sein durch Senden eines Testsignals, beispielsweise eines harmonischen Sinus-Signals, und Abgleich in der digitalen Signalverarbeitungseinheit durch Vorverzerren des Basisband-Nutzsignals zum einen durch Addieren eines Offsets zur Inphase- oder Quadraturkomponente und zum anderen durch Beeinflussen der Phasenverschiebung zwischen I- und Q-Signalen. Derart erfaßte Korrekturwerte zum einen für die Träger- und zum anderen für die Seitenbandunterdrückung, die in diesem Testsignalbetrieb ermittelt werden, können anschließend in einem Speicher der digitalen Signalverarbeitungseinheit abgelegt werden und im normalen Sendebetrieb zum Abgleich des Senders herangezogen werden.

Gemäß dem vorgeschlagenen Prinzip kann der beschriebene Abgleich durch Vorverzerrung beispielsweise bei der Produktion einmalig durchgeführt werden und/oder entweder in einem Testmodus beispielsweise beim Einschalten des Sendegerätes mit der vorgeschlagenen Sendeanordnung oder auch während des Normalbetriebs erfolgen. Damit können sowohl fertigungsbedingte, als auch temperaturbedingte beziehungsweise alterungsbedingte Drift- und Paarungstoleranzeffekte ausgeglichen werden.

Weitere Einzelheiten der Erfindung sind Gegenstand der Unteransprüche.

Die Erfindung wird nachfolgend an mehreren Ausführungsbeispielen anhand der Zeichnungen näher erläutert.

Es zeigen:
- Figur 1: anhand eines vereinfachten Blockschaltbildes ein erstes Ausführungsbeispiel der vorliegenden Erfindung,
- Figur 2: anhand eines vereinfachten Blockschaltbildes ein Ausführungsbeispiel,
- Figur 3: eine beispielhafte Anordnung eines Vorverzerrungsnetzwerkes für eine Sendeanordnung gemäß Figur 1 oder Figur 2.

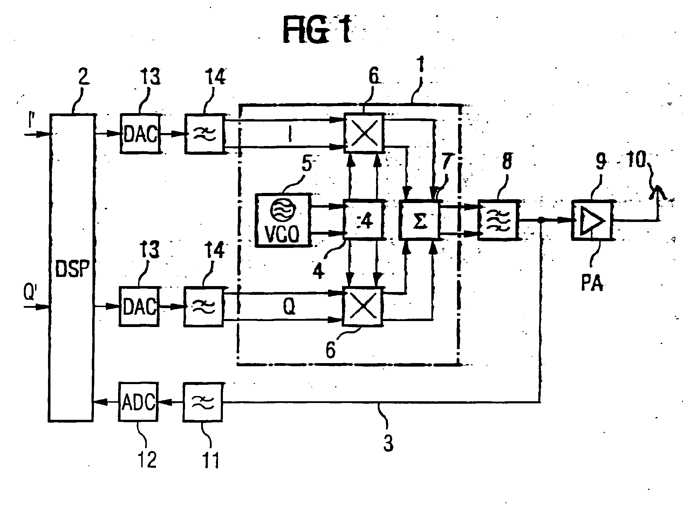

Figur 1 zeigt einen Quadratur-Modulator 1 mit einem Inphase- und Quadratureingang zum Zuführen eines komplexwertigen Nutzsignals umfassend eine Inphase-Komponente I und eine Quadratur-Komponente Q. Weiterhin weist der Quadratur-Modulator 1 einen Lokaloszillatoreingang auf, der zum Zuführen eines komplexwertigen Signals mit einer Trägerfrequenz über einen Durch-Vier-Frequenzteiler 4 an einen spannungsgesteuerten Oszillator 5 angeschlossen ist. Der Quadratur-Modulator umfaßt zwei Analogmultiplizierer 6 vom Gilbert-Typ. von denen einer mit dem Inphase-Eingang und ein weiterer mit dem Quadratur-Eingang des Quadraturmodulators gekoppelt ist und jeder der beiden. Analogmultiplizierer 6 mit seinem Lokaloszillator-Eingang über den Frequenzteiler 4 an den spannungsgesteuerten Oszillator 5 angeschlossen ist. Die Ein- und Ausgänge der Multiplizierer 6 des Quadratur-Modulators 1 sind dabei jeweils zum Führen symmetrischer Signale ausgelegt. Die Ausgänge der beiden Analogmultiplizierer 6 sind mit je einem Eingang eines Summiergliedes 7 verbunden, dessen Ausgang den Signalausgang des Quadratur-Modulators 1 bildet, der ebenfalls symmetrisch ausgebildet ist zum Fürhren differentieller Signale. An den Ausgang des Summiergliedes 7 ist weiterhin in symmetrischer Schaltungstechnik ein Bandpaßfilter 8 zur Bandbegrenzung des hochfrequenzten Sendesignals angeschlossen, dem ein Leistungsverstärker 9, englisch Power Amplifier, PA, nachgeschaltet ist. Der Leistungsverstärker 9 ist ausgangsseitig an eine Sendeantenne 10 angekoppelt. Weiterhin ist an den Ausgang des Bandpaßfilters 8 eine Rückkopplungsschleife 3 angeschlossen, welche ein Tiefpaßfilter 11 mit nachgeschaltetem Analog/Digital-Wandler 12 umfaßt und welche den Ausgang des Quadraturmodulators 1 mit der digitalen Signalverarbeitungseinheit 2, an die der Ausgang des AD-Wandlers 12 angeschlossen ist, koppelt. Der Eingang des Tiefpaßfilters 11 ist an den Ausgang des Bandpaßfilters 8 angeschlossen.

Die digitale Signalverarbeitungseinheit 2 stellt ausgangsseitig ein komplexwertiges Basisbandsignal, welches die zu sendenden Nutzdaten als Modulationssignal zur Verfügung stellt, zerlegt in eine Inphase- und eine Quadratur-Komponente I, Q bereit. Dieses Basisbandsignal wird, zerlegt in Inphase- und Quadraturzweig getrennt voneinander über je einen Digital/Analog-Wandler 13 mit nachgeschaltetem Tiefpaßfilter 14 den Nutzsignaleingängen des Quadraturmodulators 1 zugeführt.

Im normalen. Sendebetrieb kann, beispielsweise aufgrund von zu großen Paarungstoleranzen (Mismatches) der Bauteile im Frequenzteiler des Quadraturmodulators 1, die Träger- und Seitenbandunterdrückung des Modulators 1 unzureichend sein beziehungsweise einen zu großen Phasenfehler im digital modulierten Sendesignal erzeugen. Dem wird bei vorliegendem Gegenstand dadurch entgegenwirkt, daß mit dem Rückkopplungszweig 3 eine vom derart rückgekoppelten Sendesignal abgeleitete Vorverzerrung in der digitalen Signalverarheitungseinheit 2 in Phasenlagen und Amplituden der Signalkomponenten des Basisbandsignals bereitgestellt ist.

Hierfür, ist der An-Wandler 12 so ausgelegt, daß an seinem Ausgang die Einhüllende des Sendesignals bereitgestellt ist, das heißt, daß die Abtastrate des AD-Wandlers geringer ist als die Trägerfrequenz des Sendesignals, jedoch so ausgelegt ist, daß gemäß Abtasttheorem ein sicheres Erfassen des Modulationssignals, das heiß der Einhüllenden des Sendesignals, gewährleistet ist. Zur Verbesserung der Trägerunterdrückung kann der Modulator derart abgeglichen werden, daß in der digitalen Signalverarbeitungseinheit 2 die Amplitude der Inphase- oder der Quadraturkomponente I, Q des Basisband-Nutzsignals in der digitalen Signalverarbeitungseinheit 2, beispielsweise durch Addieren eines Gleichspannungsoffsets zu einer der Signalkomponenten, verändert wird. Mit vorliegender Anordnung kann alternativ oder zusätzlich die Seitenbandunterdrückung ebenfalls durch eine Vorverzerrung in der digitalen Signalverarbeitungseinheit reduziert werden. Hierdurch wird bei einem Abgleich des Mobilfunksenders die Phasenverschiebung zwischen Inphase- und Quadraturkomponente entsprechend beeinflußt und das Seitenband dadurch unterdrückt.

Ein automatischer Abgleich der Sendeanordnung gemäß der Figur 1 kann beispielsweise in einer Test-Betriebsart erfolgen. Dabei wird über die DA-Wandler 13 ein unmoduliertes Sinus-Testsignal ausgegeben und mit dem Modulator 1 auf die SendeFrequenz hochgemischt. Das gesendete Testsignal wird mit Hilfe des AD-Wandlers 12 abgetastet und es werden die Amplituden des Trägers und des Seitenbandes ermittelt. Durch die Addition eines digitalen Offsets zu der Amplitude des Inphase- oder des Quadratursignals können die analogen Offsetspannungen des Modulators ausgeregelt und somit die. Trägerfrequenz unterdrückt werden. Durch Beeinflussen der Phasenverschiebung zwischen I- und Q-Komponente des Nutzsignals kann ein Phasenmismatch der ebenfalls um 90° verschobenen Trägersignale ausgeregelt und somit das Seitenband unterdrückt werden. Die im Test-Betrieb ermittelten Werte werden anschließend in der digitalen Signalverarbeitungseinheit 2 gespeichert, um für den Sende-Normalbetrieb mit modulierten Basisbandsignalen bereitzustehen.

Die vorliegende Sendeanordnung ermöglicht eine ausreichend gute Träger- und Seitenbandunterdrückung auch bei den in Massenherstellungsverfahren üblicherweise auftretenden Paarungstoleranzen und Fehlanpassungen. Mit vorliegender Anordnung ist demnach der Betrieb mit linearen Modulationsverfahren, wie beispielsweise im Mobilfunkstandard GSM EDGE vorgesehen, möglich, welche die in Mobilfunkkanälen vorhandene Bandbreite besser ausnutzen und somit für bandbreitenintensive Mobilfunkanwendungen, wie beispielsweise Videoübertragung, Internet et cetera geeignet sind. Aufgrund der geringeren Anforderungen an die Paarungstoleranzen der verwendeten Bauelemente können bei vorliegender Sendeanordnung mit der beschriebenen Abgleichschaltung kleinere Transistoren und Widerstände, beispielsweise in 120nm CMOS(Complementary Metal Oxide Semiconductor)-Technik eingesetzt und damit Chipfläche gespart werden, weil die Offsetspannungen, die hier ausgeregelt werden können, von der Fehlanpassung der Bauteile und damit von deren Größe abhängen. Die hohe Trägerunterdrückung, die für GSM EDGE notwendig ist, kann durch den Modulatorabgleich, wie beschrieben, erzielt werden.

Figur 2 zeigt eine Ausführungsform eines Mobilfunksenders. Dieser entspricht in Aufbau und Funktion weitgehend dem Sender von Figur 1 und unterscheidet sich von diesem lediglich im Aufbau des Rückkopplungspfades 3.

Anstelle des im AD-Wandler 12 gemäß Figur 1 vorgesehenen Unter-Abtastens zum Gewinnen der Einhüllenden des Sendesignals, ist bei der Sendeanordnung gemäß Figur 2 ein zusätzlicher Abwärtsmischer 15 im Rückkopplungspfad 3 vorgesehen, der mit einem ersten Signaleingang an den Ausgang des Bandpaßfilters 8 angeschlossen ist. An den Ausgang des Abwärtsmischers 15 ist ein Tiefpaßfilter 11' mit nachgeschaltetem AD-Wandler 12', welche an die nunmehr tiefere Frequenzebene angepaßt sind, angeschlossen. Der Abwärtsmischer 15 ist mit einem zweiten, dem Lokaloszillator-Eingang, über einen Frequenzteiler 16, der das gleiche Teilerverhältnis wie der Frequenzteiler 4 des Quadraturmodulators 1 aufweist, an den spannungsgesteuerten Oszillator 5 des Quadraturmodulators 1 angeschlossen. Hierdurch ist am Ausgang des Frequenzmischers 15 die Einhüllende des Sendesignals im Basisband bereitgestellt.

In alternativen Ausführungsformen könnte der Abwärtsmischer 15 auch von einem zusätzlichen Oszillator angesteuert sein.

In alternativen Ausführungsformen könnte der Frequenzteiler 16 ein anderes Teilerverhältnis als der Frequenzteiler 4 haben.

Auch eine Kombination aus den in Figuren 1 und 2 dargestellten Rückkopplungspfaden läge im Rahmen der vorliegenden Erfindung, derart, daß beispielsweise der Abwärtsmischer 15 nicht ins Basisband, sondern in eine Zwischenfrequenzebene heruntermischt und der AD-Wandler 12' eine entsprechende Unterabtastung vornimmt.

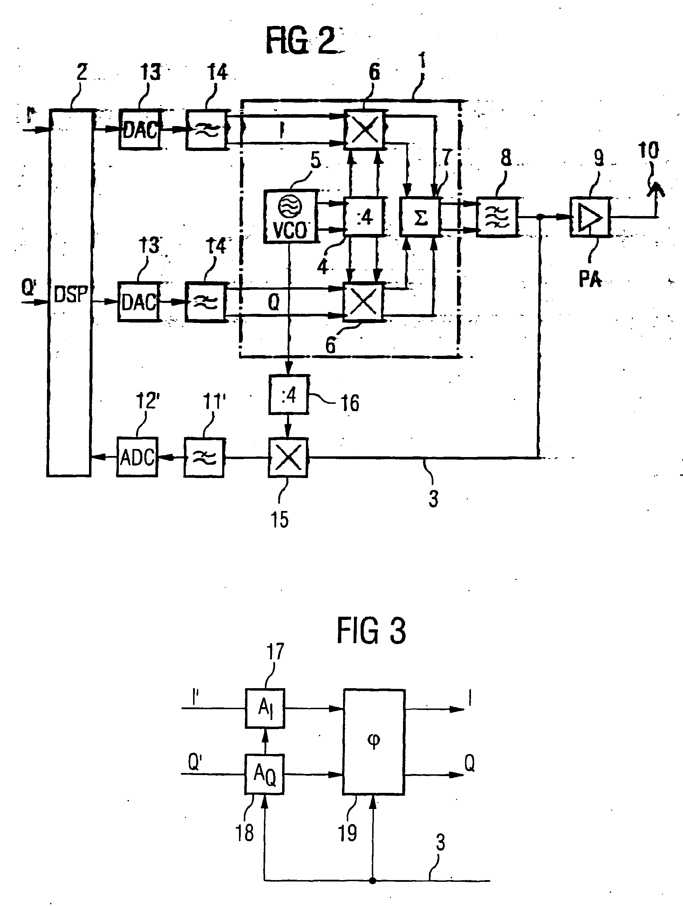

Figur 3 schließlich zeigt ein Ausführungsbeispiel für eine Vorverzerrungsschaltung, wie sie in den digitalen Signalverarbeitungseinheiten 2 gemäß Figuren 1 und 2 implementiert sein kann. Dabei ist der Rückkopplungspfad 3 zum einen mit Amplituden-Korrekturgliedern 17, 18 und zum anderen mit einem nachgeschaltetem Phasenkorrekturnetzwerk 19 jeweils an einem Steuereingang gekoppelt. Beispielsweise durch Addieren eines Offsetwertes zu Inphase- oder Quadraturkomponente eines digitalen. Modulationssignals im Basisband I', Q' mittels des entsprechenden Amplitudenkorrekturbausteins I7, I8 ist durch derartige Vorverzerrung die gewünschte Trägerunterdrückung erzielbar. Das nachgeschaltete Phasenkorrekturnetzwerk 19, welches an die Ausgänge der Amplitudenkorrekturnetzwerke 17, 18 angeschlossen ist, beeinflußt den Phasenunterschied zwischen Inphase- und Quadraturkomponente des komplexwertigen Nutzsignals im Basisband zur Verbesserung der Seitenbandunterdrückung im Quadraturmodulator 1. Ausgangsseitig am Phasenkorrekturnetzwerk 19 sind die am Ausgang der digitalen Signalverarbeitungseinheit 2 bereitgestellten Inphase- und Quadraturkomponenten I, Q vorverzerrt bereitgestellt, derart, daß am Ausgang der Sendeanordnung gemäß Figur 1 oder 2 ein Sendesignal mit guter Träger- und Seitenbandunterdrückung bereitgestellt ist.

### Bezugszeichenliste

- 1: Quadratur-Modulator
- 2: Digitale Signal verarbeitung
- 3: Rückkopplungspfad
- 4: Frequenzteiler
- 5: Spannungsgesteuerter Oszillator
- 6: Analogmischer
- 7: Summierglied
- 8: Bandpaßfilter
- 9: Leistungsverstärker
- 10: Antenne
- 11: Tiefpaßfilter
- 12: AD-Wandler
- 13: DA-Wandler
- 14: Tiefpaßfilter
- 15: Abwärtsmischer
- 16: Frequenzteiler
- 17: Amplitudenkorrektur
- 18: Amplitudenkorrektur
- 19: Phasenkorrektur
- I: Inphase-Komponente
- Q: Quadratur-Komponente

## Patentansprüche

1. Sendeanordnung, insbesondere für den Mobilfunk, aufweisend
- einen Quadratur-Modulator (1) mit einem Inphase- und Quadratureingang zum Zuführen eines komplexwertigen Nutzsignals (I, Q), mit einem Lokaloszillatorsignaleingang zum Zuführen eines komplexwertigen Signals mit einer Trägerfrequenz und mit einem Signalausgang, an dem ein moduliertes Sendesignal bereitgestellt ist,
- eine digitale Signalverarbeitungseinheit (2), die mit dem Inphase- und Quadratureingang zum Zuführen des komplexwertigen Nutzsignals (I, Q) gekoppelt ist, und
- einen Rückkopplungspfad (3), der den Signalausgang des Quadratur-Modulators (1) mit der digitalen Signalverarbeitungseinheit (2) mittels eines Analog/Digital-Wandlers (12) koppelt, an dessen Ausgang die Einhüllende des modulierten Sendesignals bereitgestellt ist,
**dadurch gekennzeichnet, daß**
der Analog/Digital-Wandler (12) im Rückkopplungspfad (3) für eine Unterabtastung des modulierten Sendesignals bezogen auf die Trägerfrequenz des modulierten Sendesignals am Eingang des Analog/Digital-Wandlers (12) ausgelegt ist.

2. Sendeanordnung nach Anspruch 1,
**dadurch gekennzeichnet, daß**
der Quadratur-Modulator (1) zwei Gilbert-Multiplizierer (6) umfaßt, von denen einem ersten eingangsseitig die Inphase-Komponente (I) und einem zweiten eingangsseitig die Quadratur-Komponente (Q) des komplexwertigen Nutzsignals zuführbar ist, und die ausgangsseitig über ein Summierglied (7) miteinander verkoppelt sind.

3. Sendeanordnung nach Anspruch 1 oder 2,
**dadurch gekennzeichnet, daß**
zwischen Rückkopplungspfad (3) und Ausgang des Quadratur-Modulators (1) ein Bandpaß-Filter (8) angeschlossen ist.

4. Sendeanordnung nach einem der Ansprüche 1 bis 3,
**dadurch gekennzeichnet, daß**
im Rückkopplungs-Pfad (3) ein Tiefpaß-Filter (11) vorgesehen ist, das dem Analog/Digital-Wandler (12) vorgeschaltet ist.

5. Sendeanordnung nach einem der Ansprüche 1 bis 4,
**dadurch gekennzeichnet, daß**
zur Kopplung von digitaler Signalverarbeitungseinheit (2) und Quadratur-Modulator (1) sowohl in einem Inphase- als auch in einem Quadraturzweig je ein Digital/Analog-Wandler (13) mit nachgeschaltetem Tiefpaß-Filter (14) vorgesehen ist.

6. Sendeanordnung nach einem der Ansprüche 1 bis 5,
**dadurch gekennzeichnet, daß**
die digitale Signalverarbeitungseinheit (2) Mittel zum Beeinflussen von Amplituden- und Phasenlage (17, 18, 19) des komplexwertigen Nutzsignals (I, Q) in Abhängigkeit von der Einhüllenden des Sendesignals aufweist, die vom Rückkopplungs-Pfad (3) bereitgestellt wird.

7. Sendeanordnung nach einem der Ansprüche 1 bis 6,
**dadurch gekennzeichnet, daß**
die digitale Signalverarbeitungseinheit (2) einen Speicher zum Ablegen von Vorverzerrungsinformationen umfaßt, die in einem Einstellbetrieb in Abhängigkeit von der Einhüllenden des Sendesignals ermittelt werden.

## Claims

1. Transmitting arrangement, in particular for mobile radio, having
- a quadrature modulator (1) having an in-phase and quadrature input for supplying a complex-value payload signal (I, Q), having a local oscillator signal input for supplying a complex-value signal at a carrier frequency, and having a signal output at which a modulated transmission signal is produced,
- a digital signal processing unit (2), which is coupled to the in-phase and quadrature input for supplying the complex-value payload signal (I, Q), and
- a feedback path (3), which couples the signal output of the quadrature modulator (1) to the digital signal processing unit (2) by means of an analogue/digital converter (12), at whose output the envelope of the modulated transmission signal is produced,
**characterized in that**
the analogue/digital converter (12) in the feedback path (3) is designed for undersampling of the modulated transmission signal with respect to the carrier frequency of the modulated transmission signal at the input of the analogue/digital converter (12).

2. Transmitting arrangement according to Claim 1,
**characterized in that**
the quadrature modulator (1) has two Gilbert multipliers (6), a first of which can be supplied on the input side with the in-phase component (I) and a second of which can be supplied on the input side with the quadrature component (Q) of the complex-value payload signal, and which are coupled to one another on the output side via an adder (7).

3. Transmitting arrangement according to Claim 1 or 2,
**characterized in that**
a bandpass filter (8) is connected between the feedback path (3) and the output of the quadrature modulator (1).

4. Transmitting arrangement according to one of Claims 1 to 3,
**characterized in that**
a low-pass filter (11) is provided in the feedback path (3) and is connected upstream of the analogue/digital converter (12).

5. Transmitting arrangement according to one of Claims 1 to 4,
**characterized in that**
in each case a digital/analogue converter (13) with a downstream low-pass filter (14) is provided both in an in-phase branch and in a quadrature branch, in order to couple the digital signal processing unit (2) and the quadrature modulator (1).

6. Transmitting arrangement according to one of Claims 1 to 5,
**characterized in that**
the digital signal processing unit (2) has means for influencing the amplitude and phase angle (17, 18, 19) of the complex-value payload signal (I, Q) as a function of the envelope of the transmission signal, which is produced by the feedback path (3).

7. Transmitting arrangement according to one of Claims 1 to 6,
**characterized in that**
the digital signal processing unit (2) has a memory for storing preemphasis information, which is determined in an adjustment mode as a function of the envelope of the transmission signal.

## Revendications

1. Dispositif d'émission, destiné notamment à la téléphonie mobile, comprenant
- un modulateur à déphasage en quadrature (1) comportant une entrée en phase et une entrée en quadrature destinées à amener un signal utile complexe (I, Q), une entrée de signal d'oscillateur local destinée à amener un signal complexe comportant une fréquence porteuse et une sortie de signal à laquelle est délivré un signal d'émission modulé,
- une unité de traitement de signal numérique (2) qui est couplée à l'entrée en phase et en quadrature pour amener le signal utile complexe (I, Q), et
- une branche de rétroaction (3) qui couple la sortie de signal du modulateur à décalage en quadrature (1) à l'unité de traitement de signal numérique (2) au moyen d'un convertisseur analogique/numérique (12) dont la sortie délivre l'enveloppe du signal d'émission modulé,
**caractérisé en ce que**
le convertisseur analogique/numérique (12) dans la branche de rétroaction (3) est conçu pour effectuer un sous-échantillonnage du signal d'émission modulé par rapport à la fréquence porteuse du signal d'émission modulé à l'entrée du convertisseur analogique/numérique (12).

2. Dispositif d'émission selon la revendication 1, **caractérisé en ce que** le modulateur à déphasage en quadrature (2) comporte deux multiplicateurs de Gilbert (6) dont un premier peut recevoir à l'entrée la composante en phase (I) et dont un deuxième peut recevoir à l'entrée la composante en quadrature (Q) du signal utile complexe, et qui sont couplés l'un à l'autre en sortie par le biais d'un élément de sommation (7).

3. Dispositif d'émission selon la revendication 1 ou 2, **caractérisé en ce qu'**un filtre passe-bande (8) est raccordé entre la branche de rétroaction (3) et la sortie du modulateur à déphasage en quadrature (1).

4. Dispositif d'émission selon l'une des revendications 1 à 3, **caractérisé en ce qu'**un filtre passe-bas (11) est prévu dans la branche de rétroaction (3) et est monté en amont du convertisseur analogique/numérique (12).

5. Dispositif d'émission selon l'une des revendications 1 à 4, **caractérisé en ce qu'**il est prévu, aussi bien dans une branche en phase que dans une branche en quadrature, un convertisseur numérique/analogique (13), en aval duquel est monté un filtre passe-bas (14), pour coupler l'unité de traitement de signal numérique (2) et le modulateur à déphasage en quadrature (1).

6. Dispositif d'émission selon l'une des revendications 1 à 5, **caractérisé en ce que** l'unité de traitement de signal numérique (2) comporte des moyens permettant d'influer sur la position d'amplitude et la position de phase (17, 18, 19) du signal utile complexe (I, Q) en fonction de l'enveloppe du signal d'émission qui est délivrée par la branche de rétroaction (3).

7. Dispositif d'émission selon l'une des revendications 1 à 6, **caractérisé en ce que** l'unité de traitement de signal numérique (2) comporte une mémoire destinée à stocker des informations de prédistorsion qui ont été déterminées dans un mode de réglage en fonction de l'enveloppe du signal d'émission.
